# EUROPÄISCHE PATENTSCHRIFT

(11) **EP 2 858 900 B1**
(45) Veröffentlichungstag und Bekanntmachung des Hinweises auf die Patenterteilung: **28.03.2018**
(21) Anmeldenummer: 13728958.3
(22) Anmeldetag: 05.06.2013
(51) Int. Cl.: B60R 11/02, G10K 11/178, B64D 11/00, B60N 2/48, H04R 5/02

(54) **FLUGZEUGSITZ, AUDIOSYSTEM UND FLUGZEUG**
AIRPLANE SEAT, AUDIO SYSTEM, AND AIRPLANE
SIÈGE D'AVION, SYSTÈME AUDIO ET AVION

(30) Priorität: 06.06.2012 DE 102012209563
(43) Veröffentlichungstag der Anmeldung: 15.04.2015
(73) Patentinhaber: Lufthansa Technik AG, 22335 Hamburg (DE)
(72) Erfinder: NISS, Frank, 22453 Hamburg (DE)
(74) Vertreter: Müller Verweyen
(86) Internationale Anmeldenummer: PCT/EP2013/001639
(87) Internationale Veröffentlichungsnummer: WO 2013/182297

(56) Entgegenhaltungen:
- WO-A1-00/14722
- WO-A1-2005/070727
- JP-A- 2009 017 094
- US-A1- 2011 081 038
- US-B1- 6 744 898

## Beschreibung

Die Erfindung betrifft ein Flugzeug mit den Merkmalen des Oberbegriffs von Anspruch 1.

Flugzeuge sind auf Mittel- und Langstreckenflügen in der Regel mit Bordunterhaltungssystemen ausgestattet, durch die den Passagieren während des Fluges Audio- und Videodaten zur Verfügung gestellt werden.

Dazu werden den Passagieren üblicherweise Kopfhörer zur Verfügung gestellt, über die die Audiodaten in Schall umgewandelt, und so wiedergegeben werden.

Offene Lautsprecher sind für den Einsatz im Flugzeug nicht geeignet, da Passagiere durch die Nutzung von solchen offenen Lautsprechern von ihren Sitznachbarn gestört würden.

Dies liegt insbesondere in der Tatsache begründet, dass die Lautsprecher sehr laut eingestellt sein müssten, um während des Fluges in der Kabine die lauten Hintergrundgeräusche der Triebwerke zu übertönen.

Die Kopfhörer werden jedoch von einigen Passagieren als störend empfunden. Sowohl die Audiokabel als auch das konstante Aufliegen auf bzw. in den Ohren kann dabei als störend und unangenehm empfunden werden.

Zusätzlich müssen die Kopfhörer bei jedem Flug aufwendig ausgeteilt und eingesammelt werden.

Aus der WO 2005/070727 A1 ist eine Vorrichtung bekannt, die den Kopf eines Passagiers in einer Sitzposition umgibt. Die Vorrichtung umfasst zwei schalenartige Elemente, die sich um eine vertikale Achse schwenken lassen, so dass die schalenartigen Elemente den Kopf des Passagiers in einer geeigneten Position umgeben. Die Vorrichtung versorgt den Passagier gezielt in dessen Ein- und Ausatembereich, d.h. in der Nähe von Mund und Nase, mit Frischluft. Ferner weist die Vorrichtung Lautsprecher auf, deren Lautstärke in Abhängigkeit des Schwenkwinkels der schalenartigen Elemente einstellbar ist.

Weiter ist aus der WO 00/14722 A1 eine Lärmreduzierungseinrichtung für eine Sitz bekannt, wobei zur Erzeugung von Gegenschall ein Mikrofon und ein Lautsprecher vorgesehen ist. Diese sind an einer Kopfstütze angeordnet und sind in ihrer Position verstellbar.

Die JP 2009 017094 A offenbart ein Lautsprechersystem für einen Sitz, wobei das Lautsprechersystem dazu eingerichtet ist, eine Beschallungsrichtung in Abhängigkeit einer Hörposition des Passagiers in dem Sitz einzustellen.

Ferner ist auch aus der US 6 774 898 B1 ein Lautsprechersystem für einen Sitz bekannt, das an einer Kopfstütze angeordnet ist. Die Lautsprecher sind auch bei dieser Lösung schwenkbar an der Kopfstütze angeordnet, so dass sie in eine für den Passagier günstige Position gebracht werden können. Ein ähnliches System ist auch aus der US 2011/081038 A1 bekannt.

Der Erfindung liegt demnach die Aufgabe zugrunde, ein Flugzeug bereitzustellen, bei dem die oben genannten Probleme reduziert sind.

Die Erfindung löst diese Aufgabe mit den Merkmalen des unabhängigen Anspruchs 1. Somit wird zur Lösung der Aufgabe ein Flugzeugsitz mit einem Audiosystem zur Wiedergabe von Audiodaten vorgeschlagen, wobei das Audiosystem eine Lautstärkenregelung und/oder eine Lärmkompensationsregelung sowie ein Kopfstützenelement mit einem in einem Schwenkwinkel α schwenkbaren Lautsprecherelement umfasst, wobei die Lautstärke und/oder der Grad der Lärmkompensation abhängig von dem Schwenkwinkel α geregelt ist.

Das bedeutet, dass die Lautstärke beispielsweise lauter oder leiser geregelt wird, je nachdem in welche Position das Lautsprecherelement geschwenkt wird. In einem Ausführungsbeispiel kann die Lautstärke bei einem bestimmten Schwenkwinkel α gleich Null sein und erst beim Erreichen eines anderen Schwenkwinkels α hörbare Intensitäten annehmen.

Das Audiosystem kann dabei eine Lautstärkenregelung oder eine Lärmkompensationsregelung umfassen, in einer bevorzugten Ausgestaltung der Erfindung werden jedoch beide Regelungen vorgesehen.

Somit wird erfindungsgemäß einerseits ein Audiosystem für einen Flugzeugsitz zur Wiedergabe von Audiodaten mit einer Lautstärkenregelung und einem Kopfstützenelement vorgeschlagen, wobei das Kopfstützenelement mindestens ein in einem Schwenkwinkel α schwenkbares Lautsprecherelement umfasst und die Lautstärke der wiedergegebenen Audiodaten durch die Lautstärkenregelung abhängig von dem Schwenkwinkel α geregelt ist.

Erfindungsgemäß wird zudem ein Audiosystem für einen Flugzeugsitz zur Wiedergabe von Audiodaten mit einer Lärmkompensationsregelung und einem Kopfstützenelement vorgeschlagen, welches mindestens ein Mikrofon und mindestens ein in einem Schwenkwinkel α schwenkbares Lautsprecherelement umfasst, und wobei der Grad der Lärmkompensation abhängig von dem Schwenkwinkel α geregelt ist.

Eine solche Regelung der Lautstärke und/oder der Lärmkompensation, abhängig von dem Schwenkwinkel α, ermöglicht es, die Wiedergabe der Audiodaten so zu gestalten, dass sie nur für den Zielempfänger hörbar ist und benachbarte Passagiere durch die Wiedergabe nicht gestört werden.

Unter Lärmkompensation ist dabei destruktiver Interferenzschall zu verstehen. Es wird ein sogenannter "Gegenschall" auf die Ohren des Passagiers gegeben. Dieser Gegenschall ist vorzugsweise ein um 180 Grad phasenverschobenes Audiosignal des Lärmpegels an den Ohren des Passagiers.

Unter dem Grad der Lärmkompensation ist die Stärke des Gegenschallsignals zu verstehen. Das bedeutet, dass beispielsweise ein stärkeres oder schwächeres Gegenschallsignal erzeugt wird, je nachdem in welche Position das Lautsprecherelement geschwenkt wird. In einem Ausführungsbeispiel kann die Lärmkompensation bei einem bestimmten Schwenkwinkel α gleich Null sein und erst beim Erreichen eines anderen Schwenkwinkels α eingeschaltet werden. Der Grad der Lärmkompensation kann beispielsweise auch als der Differenzbetrag des Schalldruckpegels gesehen werden. So werden bei geringer Lärmkompensation beispielsweise nur wenige Dezibel Lärm in einem bestimmten Frequenzbereich kompensiert, bei einem höheren Grad der Lärmkompensation dagegen mehr.

Die Lärmkompensation sorgt dafür, dass der Passagier den Flugzeuglärm deutlich weniger hört und ihm das Flugzeug somit leiser vorkommt. Um die Höhe und Frequenz des Gegenschalls zu bestimmen, werden vorzugsweise Mikrofone am Kopfstützenelement vorgesehen. Die Mikrofone sind dabei nahe den Passagierohren angeordnet.

Es werden vorzugsweise mehrere erfindungsgemäße Flugzeugsitze nebeneinander angeordnet. Somit wird erfindungsgemäß auch ein Flugzeug mit einem ersten Flugzeugsitz und einem daneben angeordneten zweiten Flugzeugsitz vorgeschlagen, wobei der erste und der zweite Flugzeugsitz wie zuvor beschrieben ausgestaltet sind, und wobei das Audiosystem des ersten Flugzeugsitzes dazu eingerichtet ist, die Lautstärke und/oder die Lärmkompensation der Audiodaten so einzustellen, dass die wiedergegebenen Audiodaten im Wesentlichen nur für den Passagier im ersten Flugzeugsitz hörbar sind.

Zusätzlich dazu kann auch das Audiosystem des zweiten Flugzeugsitzes entsprechend eingerichtet sein. Dementsprechend ist das Audiosystem des zweiten Flugzeugsitzes vorzugsweise dazu eingerichtet, die Lautstärke und/oder die Lärmkompensation so einzustellen, dass die wiedergegebenen Audiodaten im Wesentlichen nur für den Passagier im zweiten Flugzeugsitz hörbar sind.

Dabei meint "im Wesentlichen nur für den Passagier im ersten Flugzeugsitz hörbar", dass der Sitznachbar zwar unter Umständen in der Lage ist, einzelne Wiedergabefragmente wahrzunehmen, diese für ihn jedoch so leise sind, dass er sich nicht gestört fühlt. Die Hintergrundgeräusche während des Fluges übertönen die wiedergegebenen Audiodaten deutlich, so dass sie von dem Sitznachbarn kaum wahrnehmbar sind, obwohl sie beim Stillstand der Triebwerke normal verständlich wären. Vorzugsweise wird die Wiedergabe der Audiosignale von dem Audiosystem so geregelt, dass die Lautstärke der wiedergegebenen Audiodaten im Bereich der Ohren des Sitznachbarn kleiner als 8 sone (70 phon) ist. Bevorzugt ist die Lautstärke kleiner als 5,65 sone (65 phon), weiter bevorzugt kleiner als 2,83 sone (55 phon), geregelt.

Zudem kann die Lautstärke und/oder Lärmkompensation des Audiosystems des ersten Sitzes bevorzugt abhängig von der Stellung der Lautsprecherelemente des zweiten Sitzes geregelt sein. Hat der Sitznachbar im zweiten Flugzeugsitz beispielsweise auch die Lautsprecherelemente vollständig eingeklappt, ist für ihn eine erhöhte Lautstärke am ersten Flugzeugsitz weniger störend, so dass das Audiosystem des ersten Sitzes eine vergleichsweise erhöhte Lautstärke erlaubt bzw. vorsieht.

Erfindungsgemäß ist das Audiosystem des ersten Flugzeugsitzes dazu eingerichtet, bei der Lärmkompensation und/oder Lautstärkenregelung die an dem zweiten Flugzeugsitz zur Wiedergabe bestimmten Audiodaten zu nutzen. Die an dem benachbarten Flugzeugsitz zur Ausgabe bestimmten Audiosignale können beispielsweise digital abgerufen und zur Generierung des Gegenschalls genutzt werden. Die Übertragung der Audiodaten von dem zweiten Flugzeugsitz zu dem ersten Flugzeugsitz kann elektrisch oder optisch erfolgen. Es ist weiterhin vorteilhaft, wenn weitere Nachbarsitze ihre zur Ausgabe bestimmten Audiodaten an das Audiosystem des ersten Sitzes übertragen. Dies können beispielsweise die Nachbarsitze rechts und links des ersten Flugzeugsitzes sein. In möglichen Ausführungsformen können auch die Audiodaten des vorderen und/oder hinteren Nachbarsitzes an den ersten Flugzeugsitz übertragen werden.

Auf diese Weise kann der Gegenschall noch deutlich präziser auf die Umgebungsgeräusche, insbesondere auf die Wiedergabe am Nachbarsitz, abgestimmt werden, da es keiner Rückkopplung bzw. der Aufnahme der am zweiten Flugzeugsitz wiedergegebenen Audiodaten bedarf. Entgegen der Hintergrundgeräusche, wie beispielsweise dem Triebwerkslärm, sind die zur Wiedergabe bestimmten Audiodaten des zweiten Flugzeugsitzes im System bekannt und können daher gezielt dazu genutzt werden, die Lärmkompensation für den Passagier im ersten Sitz deutlich zu verbessern. Auf diese Weise kann die Störung durch einen Sitznachbarn, der beispielsweise Musik hört oder einen Film schaut, minimiert werden.

Neben der Übertragung des Audiosignals werden vorteilhaft weitere Daten übertragen, die zur optimierung der Lärmkompensation genutzt werden können. Die weiteren Daten können den aktuellen Schwenkwinkel α und/oder den eingestellten Lautstärkepegel des zweiten Flugzeugsitzes bzw. der Nachbarsitze umfassen. Weiterhin können den übertragenden Audiodaten Informationen zum Abstand und/oder zur Richtung der Nachbarsitze zugeordnet werden, wodurch die akustische Laufzeit und eine Verzögerung in der Lärmkompensation präzise bestimmt werden können, was die Lärmkompensation der Wiedergabe des Nachbarsitzes zusätzlich verbessern kann. In weiteren möglichen Ausführungsformen können die Verzögerung und die Lärmkompensation in einem Stereobetrieb für die rechten und linken Audiodaten eines Nachbarsitzes getrennt bestimmt werden. Dies ist insbesondere bei einer engen Sitzanordnung vorteilhaft, da das rechte und linke Lautsprecherelement eines zweiten Flugzeugsitzes einen proportional stark abweichenden Abstand von einem eng angeordneten ersten Flugzeugsitz haben. Aufgrund der Konstellation in einem Flugzeug bleibt auch die Richtung, aus der eine störende Wiedergabe eines Nachbarsitzes an einem ersten Flugzeugsitz eintrifft, konstant. Daher können die Verzögerungen eines Gegenschallsignals zur Kompensation der Wiedergabe eines Nachbarsitzes für ein rechtes und ein linkes Lautsprecherelement eines Flugzeugsitzes unterschiedlich sein. Handelt es sich beispielsweise um die Audiodaten von einem zweiten Flugzeugsitz, der rechts von einem ersten Flugzeugsitz angeordnet ist, kann das Gegenschallsignal am linken Lautsprecherelement des ersten Flugzeugsitzes länger verzögert werden als am rechten Lautsprecherelement.

Die Abhängigkeit der Lautstärken- und/oder Lärmkompensationsregelung vom Schwenkwinkel α umfasst eine Reihe von bevorzugten Ausgestaltungen. Beispielsweise kann bei einem Schwenkwinkel von α = 0, also bei vollständig ausgeklapptem Lautsprecherelement, die Wiedergabe ausgeschaltet sein. Sobald der Schwenkwinkel α größer als Null ist oder beispielsweise einen vorbestimmten Schwellwinkel αₛ überschreitet, wird die Lautstärke bzw. die Lärmkompensation gestartet.

Vorzugsweise ist die Lautstärke und/oder der Grad der Lärmkompensation der wiedergegebenen Audiodaten mit zunehmendem Schwenkwinkel α erhöht. Somit wird abhängig von dem Winkel α die Lautstärke bzw. die Lärmkompensation erhöht, ein Einklappen des Lautsprecherelements führt zu einem lauteren bzw. deutlicheren Signal. Durch die Lärmkompensation werden vorzugsweise die niedrigen Breitbandstörgeräusche der Flugzeugtriebwerke kompensiert, so dass Audiosignale mit höherer Frequenz besser wahrgenommen werden können. In dem schwenkbaren Lautsprecherelement sind Audioquellen angeordnet, die mit steigendem Schwenkwinkel α zunehmend direkt auf die Ohren des Passagiers gerichtet werden.

Durch die genaue Ausrichtung der Audioquellen auf die Ohren des Passagiers ist es möglich, die Lautstärke stärker zu erhöhen, ohne dass benachbarte Passagiere gestört werden. Dabei ist es bevorzugt, wenn das Audiosystem zwei schwenkbare Lautsprecherelemente umfasst. Die Lautsprecherelemente sind dann auf beiden Seiten des Passagierkopfes angeordnet und umschließen ihn bei Erhöhung des Schwenkwinkels in steigendem Maße.

Das Lautstärkenmaximum und/oder die höchste Lärmkompensation ist vorzugsweise bei einem Schwenkwinkel α ≈ 90° eingestellt. Das bedeutet, dass in keiner anderen Stellung der Lautsprecherelemente eine höhere Lautstärke bzw. eine größere Lärmkompensation stattfindet. Das Lautsprecherelement bzw. die Lautsprecherelemente sind dann parallel zu den Passagierohren und zueinander ausgerichtet. Aufgrund dieser Stellung kann die Audiowiedergabe vom Passagier am deutlichsten wahrgenommen werden und das Signal ist für benachbarte Passagiere noch schwächer, da sie sich dann vollständig auf der von der Audioquelle abgewandten Seite des Lautsprecherelements befinden.

Die Lautstärke und/oder der Grad der Lärmkompensation der wiedergegebenen Audiodaten werden vorzugsweise mit zunehmendem Schwenkwinkel α kontinuierlich bzw. stetig erhöht. In alternativen Ausführungsformen kann die Erhöhung der Lautstärke und/oder der Grad der Lärmkompensation stufenweise mit zunehmendem Schwenkwinkel erfolgen, wobei vorzugsweise mindestens drei, weiter vorzugsweise mindestens vier Stufen vorgesehen sind, so dass dem Passagier die Erhöhung zumindest kontinuierlich mit zunehmenden Schwenkwinkel α erscheint.

In weiteren vorteilhaften Ausführungsformen wird die Lautstärke ab einem Schwenkwinkel α = 45°, weiterhin vorzugsweise ab einem Schwenkwinkel α = 60°, nicht weiter erhöht oder in möglichen Ausführungsformen sogar wieder gesenkt. Für den Passagier kann die Lautstärke scheinbar weiter steigen, da sich der Abstand vom Lautsprecherelement zu dem Ohr des Passagiers mit zunehmendem Schwenkwinkel α erheblich verkürzt.

Vorzugsweise umfasst das schwenkbare Lautsprecherelement eine Polsterfläche, welche über der im Lautsprecherelement angeordneten Audioquelle angeordnet ist und diese dadurch überdeckt, und welche für von der Audioquelle ausgesendeten Schall durchlässig ist. Die Polsterfläche enthält dabei vorzugsweise weiche Polsterelemente, durch die das Kopfanlehnen angenehm ist, sie ist jedoch vorzugsweise auch durchlässig, beispielsweise löchrig, so dass der von der Audioquelle ausgesendete Schall sie gut durchdringen kann.

Zudem ist es bevorzugt, dass das Audiosystem dazu eingerichtet ist, für Ansagen des Flugkapitäns oder des Flugpersonals die Lautstärke und/oder die Lärmkompensation anzupassen, so dass die Ansagen besonders klar und deutlich verständlich werden. Beispielsweise können etwaige Bordunterhaltungsmedien pausiert werden und/oder zusätzlich das hörbare Triebwerksgeräusch durch die Lärmkompensation verringert werden.

Die Erfindung wird im Folgenden anhand bevorzugter Ausführungsformen unter Bezugnahme auf die beigefügten Figuren erläutert. Dabei zeigt:
- Fig. 1: eine Frontansicht von drei nebeneinander angeordneten erfindungsgemäßen Flugzeugsitzen;
- Fig. 2a: eine Draufsicht eines vollständig geöffneten Kopfstützenelements;
- Fig. 2b: eine Draufsicht eines halb geöffneten Kopfstützenelements;
- Fig. 2c: eine Draufsicht eines zugeklappten Kopfstützenelements;
- Fig. 3a: eine Frontansicht des geöffneten Kopfstützenelements aus der Fig. 2a; und
- Fig. 3c: eine Frontansicht des zugeklappten Kopfstützenelements aus der Fig. 2c.

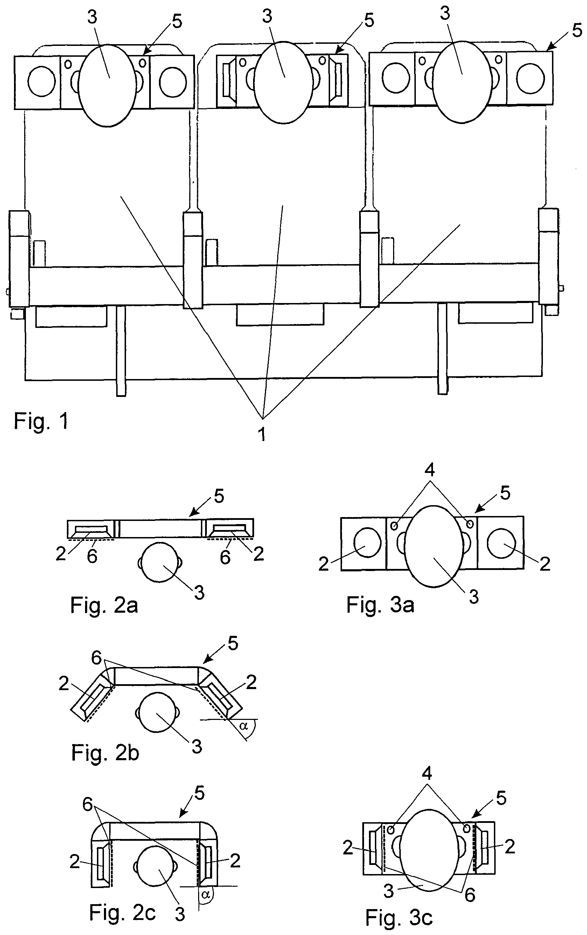

In der Fig. 1 sind drei nebeneinander angeordnete Flugzeugsitze 1 dargestellt. Ein Flugzeug weist üblicherweise eine Vielzahl solcher Sitzgruppen auf, die alternativ auch zwei, vier oder mehr Flugzeugsitze 1 umfassen können. Die Flugzeugsitze weisen erfindungsgemäß jeweils ein Kopfstützenelement 5 auf.

Das Kopfstützenelement 5 ist Teil eines Audiosystems und im mittleren Flugzeugsitz 1 im zugeklappten Zustand dargestellt, in den äußeren Flugzeugsitzen 1 ist es jeweils im offenen Zustand zu sehen.

Über das Audiosystem werden den Passagieren im Flug Audiodaten wiedergegeben. Die Regelung der Lautstärke der Audiodaten erfolgt dabei über eine Lautstärkenregelung. Zusätzlich umfasst das Audiosystem eine Regelung zur Lärmkompensation, über die die lauten Hintergrundgeräusche während des Fluges reduziert werden sollen.

Die unterschiedlichen Stellungen des Kopfstützenelements 5 sind in den Fig. 2a bis 2c sowie in den Fig. 3a und 3c dargestellt. Das Kopfstützenelement 5 weist zwei schwenkbare Lautsprecherelemente 2 auf, die jeweils eine Audioquelle zur Umwandlung der Audiodaten in Schall enthalten. Das Kopfstützenelement 5 weist zudem zwei Mikrofone 4 auf, die seitlich am Passagierkopf angeordnet sind und über die vorzugsweise Geräuschinformationen für die Lärmkompensation gesammelt werden.

Je nach Stellung der Lautsprecherelemente 2 wird ein unterschiedlicher Schwenkwinkel α eingenommen. Im vollständig geöffneten Zustand, der in den Fig. 2a und 3a dargestellt ist, ist der Schwenkwinkel α = 0°. Im vollständig geschlossenen Zustand, der in den Fig. 2c und 3c dargestellt ist, beträgt der Schwenkwinkel α ≈ 90°. Die Stellung der Lautsprecherelemente 2 ist vorzugsweise symmetrisch, so dass beide,Lautsprecherelemente 2 automatisch denselben Schwenkwinkel α einnehmen, wenn einer von beiden verstellt wird.

Dementsprechend nimmt der Schwenkwinkel α zwischen diesen Endpositionen Werte zwischen 0° und 90° ein. Je nach Schwenkwinkel werden die Lärmkompensation und die Lautstärke unterschiedlich hoch geregelt. In der geschlossenen Stellung der Fig. 2c und 3c sind die Lärmkompensation und die Lautstärke am höchsten eingestellt, wohingegen im ausgeklappten Zustand der Fig. 2a und 3a die Wiedergabe ausgeschaltet ist. Demnach werden in der geschlossenen Stellung die Triebwerksgeräusche während des Fluges am meisten kompensiert.

Sobald der Passagier die Audiowiedergabe starten möchte, wird durch das Einklappen der Lautsprecherelemente 2 die Wiedergabe gestartet bzw. die Lautstärke erhöht.

Das Einklappen erfolgt manuell, es kann jedoch auch durch entsprechende Knöpfe oder Regler erfolgen. Dazu sind die Lautsprecherelemente 2 in einer Ausgestaltung der Erfindung mit elektrischen Aktuatoren versehen, über die die Schwenkbewegung ferngesteuert möglich ist.

Auf den dem Passagierkopf 3 zugewandten Innenseiten der Lautsprecherelemente 2 sind Polsterflächen 6 angeordnet. Die Polsterflächen 6 sind über Audioquellen im Lautsprecherelement angeordnet, also über dem Bereich, in dem die Audiodaten in für den Passagier hörbaren Schall umgewandelt werden.

Die Polsterflächen 6 dienen dem Passagier einerseits als Kopfstütze, so dass er beispielsweise seinen Kopf gegen die Polsterfläche lehnen kann. Die Polsterflächen 6 sind jedoch auch durchlässig für Schall und dazu beispielsweise löchrig oder als Abstandsgewirk und/oder Abstandstextil ausgebildet, so dass sie die Funktion eines Polsters und einer für Schall durchlässigen Membran vereinen.

### Bezugszeichenliste:

- 1: Flugzeugsitz
- 2: Lautsprecherelement
- 3: Passagierkopf
- 4: Mikrofon
- 5: Kopfstützenelement
- 6: Polsterfläche

## Patentansprüche

1. Flugzeug mit einem ersten Flugzeugsitz (1) und einem daneben angeordneten zweiten Flugzeugsitz (1), wobei
- der erste und der zweite Flugzeugsitz (1) ein Audiosystem zur Wiedergabe von Audiodaten aufweist, wobei
- das Audiosystem eine Lautstärkenregelung und/oder eine Lärmkompensationsregelung sowie ein Kopfstützenelement (5) mit einem in einem Schwenkwinkel α schwenkbaren Lautsprecherelement (2) umfasst, wobei
- die Lautstärke und/oder der Grad der Lärmkompensation abhängig von dem Schwenkwinkel α geregelt ist, wobei
- das Audiosystem des ersten Flugzeugsitzes (1) dazu eingerichtet ist, die Lautstärke und/oder die Lärmkompensation der Audiodaten so einzustellen, dass die wiedergegebenen Audiodaten im Wesentlichen nur für den Passagier im ersten Flugzeugsitz (1) hörbar sind, **dadurch gekennzeichnet, dass**
- das Audiosystem des ersten Flugzeugsitzes (1) dazu eingerichtet ist, bei der Lärmkompensation und/oder Lautstärkenregelung die an dem zweiten Flugzeugsitz (1) zur Wiedergabe bestimmten Audiodaten zu nutzen.

2. Flugzeug nach Anspruch 1, **dadurch gekennzeichnet, dass** das Audiosystem des zweiten Flugzeugsitzes (1) dazu eingerichtet ist, die Lautstärke und/oder die Lärmkompensation so einzustellen, dass die wiedergegebenen Audiodaten im Wesentlichen nur für den Passagier im zweiten Flugzeugsitz (1) hörbar sind.

## Claims

1. Airplane having a first airplane seat (1) and a second airplane seat (1) arranged next thereto, wherein
- the first and the second airplane seat (1) comprises an audio system for playing back audio data, wherein
- the audio system comprises a volume controller and/or a noise compensation controller as well as a head rest element (5) having a loudspeaker element (2) that can be swiveled at a swivel angle α, wherein
- the volume and/or the degree of the noise compensation is/are controlled as a function of the swivel angle α, wherein
- the audio system of the first airplane seat (1) is configured to adjust the volume and/or the noise compensation of the audio data such that the played back audio data is substantially audible only to the passenger in the first airplane seat (1), **characterized in that**
- the audio system of the first airplane seat (1) is configured to use the audio data intended for playback at the second airplane seat (1) for noise compensation and/or volume control.

2. Airplane according to claim 1, **characterized in that** the audio system of the second airplane seat (1) is configured to adjust the volume and/or the noise compensation such that the played back audio data is substantially audible only to the passenger in the second airplane seat (1).

## Revendications

1. Avion comportant un premier siège d'avion (1) et un second siège d'avion (1) disposé à côté du premier, dans lequel
- le premier et le second siège d'avion (1) comportent un système audio destiné à reproduire des données audio, dans lequel
- le système audio comprend un réglage du volume et/ou un réglage de la réduction du bruit ainsi qu'un élément d'appui-tête (5) doté d'un élément de haut-parleur (2) pivotant selon un angle de pivotement α, dans lequel
- le volume et/ou le degré de la réduction du bruit est/sont réglé(s) en fonction de l'angle de pivotement α, dans lequel
- le système audio du premier siège d'avion (1) est configuré pour régler le volume et/ou la réduction du bruit des données audio de telle sorte que les données audio reproduites sont essentiellement audibles uniquement pour le passager du premier siège d'avion (1),
**caractérisé en ce que**
- le système audio du premier siège d'avion (1) est configuré pour utiliser, lors de la réduction du bruit et/ou du réglage du volume, les données audio destinées à la reproduction sur le second siège d'avion (1).

2. Avion selon la revendication 1, **caractérisé en ce que** le système audio du second siège d'avion (1) est configuré pour régler le volume et/ou la réduction du bruit de telle sorte que les données audio reproduites sont essentiellement audibles uniquement pour le passager du second siège d'avion (1).
